# EUROPEAN PATENT APPLICATION

(11) **EP 2 793 258 A1**
(43) Date of publication of application: **22.10.2014**
(21) Application number: 12857715.2
(22) Date of filing: 11.12.2012
(51) Int. Cl.: H01L 23/36, B23K 1/00, H01L 23/12, H01L 25/07, H01L 25/18

(54) **POWER MODULE SUBSTRATE, SUBSTRATE FOR POWER MODULE WITH HEAT SINK, POWER MODULE, PASTE FOR FORMING FLUX COMPONENT PENETRATION PREVENTION LAYER, AND BONDING METHOD FOR ARTICLE TO BE BONDED**

(30) Priority: 12.12.2011 JP 2011271081; 12.12.2011 JP 2011271146
(71) Applicant: Mitsubishi Materials Corporation, Chiyoda-ku Tokyo 100-8117 (JP)
(72) Inventor: NISHIKAWA Kimihito, Kitamoto-shi Saitama 364-0022 (JP); NISHIMOTO Shuuji, Kitamoto-shi Saitama 364-0022 (JP); KITAHARA Takeshi, Sunto-gun Shizuoka 410-1312 (JP); NAGASE Toshiyuki, Kitamoto-shi Saitama 364-0022 (JP)
(74) Representative: HOFFMANN EITLE
(86) International application number: PCT/JP2012/082066
(87) International publication number: WO 2013/089099

(57) **Abstract**

In a power module substrate 10, a circuit layer 12 is formed on one surface of an insulating layer 11, a metal layer 13 is formed on the other surface of the insulating layer 11, and a body to be bonded can be bonded to the other surface of the metal layer 13 using a flux. A flux component intrusion-preventing layer 51 containing an oxide and a resin is formed at a circumferential edge section of a bonding interface between the insulating layer 11 and the metal layer 13.

## Description

### Technical Field

The present invention relates to a power module substrate in which a circuit layer is formed on one surface of an insulating layer, a metal layer is formed on the other surface of the insulating layer, and a body to be bonded is bonded to the other surface of the metal layer, a power module substrate with a heat sink including the power module substrate, a power module, paste for forming a flux component intrusion-preventing layer used when forming a flux component intrusion-preventing layer for suppressing the intrusion of a flux component into a bonding interface, and a method for bonding the bonded body in which the paste for forming a flux component intrusion-preventing layer is used.

Priority is claimed on Japanese Patent Application No. 2011-271081, filed on December 12, 2011 and Japanese Patent Application No. 2011-271146, filed on December 12, 2011, the contents of which are incorporated herein by reference.

### Background Art

As the power module substrate and the power module substrate with a heat sink, for example, as described in Patent Citation 1, a power module substrate having aluminum (Al) metal plates (a circuit layer and a metal layer) bonded to both surfaces of a ceramic substrate made of aluminum nitride (AlN) and a power module substrate to which a heat sink made of aluminum is bonded through brazing have been proposed.

Patent Citation 2 proposes a cooling device of a semiconductor module in which aluminum (Al) metal plates (an upper electrode and a lower electrode) are bonded to both surfaces of an insulating substrate made of a ceramic material, and a semiconductor module having a semiconductor element bonded to the upper electrode and a top plate of a cooler made of aluminum are bonded together through brazing for which a flux is used.

Patent Citation 3 discloses a method for brazing an insulating laminated material in a power module. In this method, boron nitride or carbon powder is dispersed in a dispersion medium made of an organic compound so as to produce suspension, and the suspension is applied to the circumferential surface of an aluminum heat-transfer layer, thereby attaching a flux intrusion-preventing substance to the circumferential surface of the heat-transfer layer. In this state, the heat-transfer layer and a stress-relaxation member are brazed together using a flux, whereby the intrusion of the molten flux into an interface between an insulating plate and a metal layer along the circumferential surface of the metal layer is prevented.

As the brazing for which a flux is used, for example, as described in Patent Citations 4 and 5, Nocolok brazing for which a flux mainly containing KAlF₄ is used is known.

Nocolok brazing is a technique that mainly bonds aluminum members together, and, for example, an Al-Si-based brazing filler metal foil and the flux mainly containing KAlF₄ are disposed between aluminum members, oxide films formed on the surfaces of the aluminum members are removed by the flux, the melting of the brazing filler metal is accelerated, thereby bonding the aluminum members.

### Citation List

[Patent Citation 1] Japanese Unexamined Patent Application, First Publication No. 2007-194256
[Patent Citation 2] Japanese Unexamined Patent Application, First Publication No. 2009-105166
[Patent Citation 3] Japanese Unexamined Patent Application, First Publication No. 2011-228563
[Patent Citation 4] Japanese Unexamined Patent Application, First Publication No. 2001-012887
[Patent Citation 5] Japanese Unexamined Patent Application, First Publication No. 2010-138955

### Disclosure of Invention

### Technical Problem

However, when the power module substrate and the heat sink were bonded together through the Nocolok brazing, there was a concern that the KAlF₄ that was a flux component might intrude into the bonding interface between a ceramic plate and the metal plate in the power module substrate, and the bonding reliability between the ceramic plate and the metal plate might degrade.

Particularly, in the power module substrate with a heat sink, the bonding interface between the ceramic substrate and the metal plate, and the interface between the power module substrate and the heat sink are divided only by the metal layer, and the bonding interface and the interface are close to each other, there is a tendency for the flux component to easily intrude into the bonding interface between the ceramic plate and the metal plate in the power module substrate.

Furthermore, when the flux component was passed through the ceramic substrate and reached the circuit layer, there was a concern that the insulating property between the circuit layer and the metal layer might degrade and the substrate would become unavailable as a power module substrate.

Therefore, in Patent Citation 2, the application of a contact-preventing material (flux intrusion-preventing layer) containing boron, titanium oxide or the like to a bonding end section between the ceramic plate and the metal plate was proposed.

However, although the flux intrusion-preventing layer needs to be applied in advance before the power module substrate and the heat sink are bonded together, the power module substrate and the heat sink need to undergo many steps such as transportation between factories, conveyance in a factory and setting in a bonding jig until a step of bonding the power module substrate and the heat sink together begins, and therefore it is necessary to maintain the reliable attachment of the flux intrusion-preventing layer throughout the above-described steps.

An object of an aspect of the present invention is to provide a power module substrate capable of reliably attaching a flux intrusion-preventing layer to the circumferential edge section of a bonding interface between an insulating layer and a metal layer and capable of suppressing the degradation of the bonding reliability between the insulating layer and the metal layer even when a material to be bonded is bonded using a flux, a power module substrate with a heat sink and a power module.

An object of another aspect of the present invention is to provide paste for forming a flux component intrusion-preventing layer capable of reliably forming a flux component intrusion-preventing layer and capable of favorably bonding a bonded body and a body to be bonded and a method for bonding a bonded body.

### Technical Solution

According to a first aspect of the invention, a power module substrate is provided in which a circuit layer is formed on one surface of an insulating layer, a metal layer is formed on the other surface of the insulating layer, and a body to be bonded is bonded to the other surface of the metal layer, in which a flux component intrusion-preventing layer containing an oxide and a resin is formed at a circumferential edge section of a bonding interface between the insulating layer and the metal layer.

According to the power module substrate having the above-described configuration, since the flux component intrusion-preventing layer containing an oxide and a resin is formed at the circumferential edge section of the bonding interface between the insulating layer and the metal layer, when bonding a body to be bonded to the other surface of the metal layer using a flux, a flux component comes into contact with the oxide and is decomposed even when the flux component moves toward the insulating layer, and therefore it is possible to suppress the entering of the flux component into the bonding interface between the insulating layer and the metal layer. This is considered to be because the flux component is decomposed due to a reaction between the oxide contained in the flux component and the flux component intrusion-preventing layer, and the flux component loses the activity as a flux.

In addition, since the flux component intrusion-preventing layer contains the resin, even when vibration occurs during transportation, conveyance, setting and the like, it is possible to maintain a reliable attachment of the flux component intrusion-preventing layer to the circumferential edge section of the bonding interface between the insulating layer and the metal layer while maintaining the shape thereof.

When bonding the body to be bonded, since the resin in the flux component intrusion-preventing layer is decomposed due to heat, the majority of the flux component intrusion-preventing layer in the power module substrate after the bonding of the body to be bonded is made up of the oxide.

The composition of the flux component intrusion-preventing layer preferably contains the oxide in a range of 5 to 60% by volume, and the remainder is preferably the resin.

In this case, since the content of the oxide is set to 5% by volume or more, it is possible to reliably decompose the flux component that has come into contact with the flux component intrusion-preventing layer during brazing, and it is possible to reliably suppress entry of the flux component into the bonding interface between the insulating layer and the metal layer. Since the content of the oxide is set to 60% by volume or less, the content of the resin in the flux component intrusion-preventing layer is ensured, the adhesion force is increased by the resin, and it is possible to prevent the detachment of the flux component intrusion-preventing layer.

The flux component intrusion-preventing layer preferably forms a fillet shape. The fillet shape refers to a flared shape in which two intersecting surfaces are smoothly connected together on a concave surface.

In this case, the flux component intrusion-preventing layer is formed so as to extend to the other surface of the insulating layer and the side surfaces of the metal layer, and it is possible to reliably suppress entry of the flux component into the bonding interface between the insulating layer and the metal layer. In addition, it is possible to decrease the volume of the flux component intrusion-preventing layer to an extent at which the flux decomposition effect is obtained in comparison with the size of the coating area of the flux component intrusion-preventing layer.

The oxide is preferably one or more of TiO₂, SiO₂ and Al₂O₃. These oxides are capable of reacting with the flux component in a temperature range in which the brazing is carried out so as to decompose the flux component through an oxidation reaction or the like and deprive the flux of the activity. Particularly, it becomes possible to reliably decompose the flux mainly containing KAlF₄ used for the brazing.

An acrylic resin, a cellulose resin, a butyral resin and the like can be used as the resin, and particularly, the acrylic resin is preferred. The acrylic resin is depolymerized when heated to the temperature range in which the brazing is carried out, and therefore the acrylic resin has a favorable thermal decomposition characteristic even in an inert gas atmosphere and is capable of suppressing the resin from remaining in the flux component intrusion-preventing layer after firing.

According to another aspect of the invention, a power module substrate with a heat sink is provided including the power module substrate and a heat sink bonded to the metal layer in the power module substrate using a flux.

According to the power module substrate with a heat sink having the above-described configuration, since the flux component intrusion-preventing layer is formed at a circumferential edge of the bonding interface between the insulating layer and the metal layer, the intrusion of the flux component into the bonding interface between the insulating layer and the metal layer is prevented when bonding the heat sink. Therefore, the bonding reliability between the insulating layer and the metal layer is excellent.

When bonding the heat sink, since the resin in the flux component intrusion-preventing layer is decomposed due to heat, the majority of the flux component intrusion-preventing layer in the power module substrate with a heat sink is made up of the oxide.

According to another aspect of the invention, there is provided a power module including the power module substrate and an electronic component provided on the circuit layer. According to the power module having the above-described configuration, the insulating layer and the metal layer are reliably bonded together, whereby it is possible to significantly improve the reliability.

According to another aspect of the invention, there is provided paste for forming a flux component intrusion-preventing layer including an oxide decomposing the flux component, a resin, and a solvent, in which a viscosity at a shear rate of 10s⁻¹ at a temperature of 25°C is set in a range of 10 mPa·s to 20000 mPa·s, and a viscosity at a shear rate of 100s⁻¹ at a temperature of 25°C is set in a range of 10 mPa·s to 5000 mPa·s.

According to the paste for forming a flux component intrusion-preventing layer having the above-described configuration, since the paste contains the oxide decomposing the flux component, it is possible to detoxify the flux component when the paste comes into contact with the flux component, and it is possible to suppress the entering of the flux component into the bonding interface between a first member and a second member.

In addition, when the above-described viscosity conditions are satisfied, it is possible to apply the paste for forming a flux component intrusion-preventing layer to the periphery of the bonding interface between the first member and the second member, the applied paste for forming a flux component intrusion-preventing layer sags to the appropriate extent so as to form a favorable fillet shape, and it is possible to reliably form the flux component intrusion-preventing layer.

Particularly, when the bonding interface between the insulating layer and the metal layer, and a bonding interface between the metal layer and the heat sink are close to each other, while it is difficult to form the flux component intrusion-preventing layer, according to the paste for forming a flux component intrusion-preventing layer of the invention, since the application property and the holding property are excellent due to the appropriate viscosity, it is possible to form a desired application amount of the flux component intrusion-preventing layer in a desired cross-sectional shape.

When the viscosity at a shear rate of 10s⁻¹ is less than 10 mPa·s, there is a concern that, when the paste is applied, the sagging paste may significantly spread so as to penetrate a bonding interface between a bonded body and a body to be bonded, and bonding for which the flux is used may be hindered. In addition, when the viscosity at a shear rate of 10s⁻¹ exceeds 20000 mPa·s, since the applied paste does not sag to the appropriate extent, there is a concern that the fillet shape may be not formed, and a gap may be generated between the bonding interface and the flux component intrusion-preventing layer.

For what has been described thus far, the viscosity at a shear rate of 10s⁻¹ at a temperature of 25°C is set in a range of 10 mPa·s to 20000 mPa·s.

To reliably develop the above-described effects, the viscosity at a shear rate of 10s⁻¹ at a temperature of 25°C is preferably set in a range of 100 mPa·s to 10000 mPa·s.

When the viscosity at a shear rate of 100s⁻¹ is less than 10 mPa·s, since the paste is excessively ejected during the application of the paste, there is a concern that the paste may spread from an intended application portion, and the bonding may be hindered. When the viscosity at a shear rate of 100s⁻¹ exceeds 5000 mPa·s, it is not possible to sufficiently eject the paste when applying the paste, and there is a concern that a gap may be generated between the bonding interface and the flux component intrusion-preventing layer.

For what has been described thus far, the viscosity at a shear rate of 100s⁻¹ at a temperature of 25°C is set in a range of 10 mPa·s to 5000 mPa·s.

To reliably develop the above-described effects, the viscosity at a shear rate of 100s⁻¹ at a temperature of 25°C is preferably set in a range of 50 mPa·s to 2500 mPa·s.

The oxide is as described above.

The resin is also as described above.

The solvent is preferably a non-polar solvent. When a non-polar solvent is used, it becomes possible to accelerate the adsorption of the resin to powder, and it is possible to stabilize dispersion. Examples of the non-polar solvent include cyclohexane, methylcyclohexane, ethylcyclohexane, dibutyl ether and the like.

The paste for forming a flux component intrusion-preventing layer of the invention may contain a dispersant as necessary. The use of the dispersant can stabilize the dispersion of an oxide component. Examples of the dispersant include an anionic surfactant, a cationic surfactant and a nonionic surfactant. A preferred content of the dispersant is not limited, and is, for example, in a range of 0.01% by mass to 5% by mass of the total amount of the paste. When the content of the dispersant is within the above-described range, a dispersion effect is obtained, and the effect of the remaining dispersant is not easily generated.

The content of the oxide is preferably set in a range of 10% by mass to 80% by mass, the content of the resin is preferably set in a range of 5% by mass to 30% by mass, and the remainder is preferably the solvent. In this case, since the oxide decomposing the flux component is contained in a range of 10% by mass to 80% by mass, it is possible to reliably decompose and detoxify the flux component. When the content of the resin is in a range of 5% by mass to 30% by mass, it is possible to hold the fillet shape formed by applying the paste, and it becomes possible to reliably form the flux component intrusion-preventing layer.

According to another aspect of the invention, a method for bonding a bonded body is provided in which the bonded body having a first member and a second member bonded through a bonding interface and a material to be bonded are bonded using a flux, in which a flux component intrusion-preventing layer suppressing the intrusion of a flux component into the bonding interface is formed on the bonding interface between the first member and the second member of the bonded body using the paste for forming a flux component intrusion-preventing layer, and then the bonded body and the material to be bonded are bonded together using the flux.

According to the method for bonding a bonded body having the above-described configuration, since the flux component intrusion-preventing layer suppressing the intrusion of the flux component into the bonding interface is formed on the bonding interface between the first member and the second member of the bonded body using the paste for forming a flux component intrusion-preventing layer, it is possible to suppress the intrusion of the flux component into the bonding interface between the first member and the second member, and it becomes possible to favorably bond the bonded body and the body to be bonded without decreasing the bonding reliability at the bonding interface.

### Advantageous Effects

According to the power module substrate, the power module substrate with a heat sink and the power module that are aspects of the invention, even when a material to be bonded is bonded using a flux, it is possible to reliably attach the flux intrusion-preventing layer and to suppress a decrease in the bonding reliability between the insulating layer and the metal plate.

According to the paste for forming a flux component intrusion-preventing layer and the method for bonding a bonded body that are another aspects of the invention, when a bonded body having a first member and a second member bonded through a bonding interface and a material to be bonded are bonded together using a flux, it is possible to reliably form the flux component intrusion-preventing layer for suppressing the intrusion of the flux component into the bonding interface, and to favorably bond a bonded body and a body to be bonded.

### Brief Description of Drawings

FIG. 1 is a cross-sectional view illustrating a power module substrate of an embodiment of the invention.
FIG. 2 is a cross-sectional view of a power module substrate with a heat sink and a power module of another embodiment of the invention.
FIG. 3 is a flowchart illustrating a method for manufacturing paste for forming a flux component intrusion-preventing layer used in the embodiment.
FIG. 4 is a flowchart illustrating a method for manufacturing the power module substrate with a heat sink of the embodiment.
FIG. 5 is a cross-sectional view illustrating the method for manufacturing the power module substrate of the embodiment.
FIG. 6 is a cross-sectional view illustrating an order of forming a flux component intrusion-preventing layer.
FIG. 7 is a cross-sectional view illustrating the method for manufacturing the power module substrate with a heat sink of an embodiment.
FIG. 8 is a cross-sectional view illustrating the power module substrate of another embodiment of the invention.

### Best Mode for Carrying out the Invention

Hereinafter, individual embodiments of the invention will be described with reference to the accompanying drawings.

### [Power module substrate]

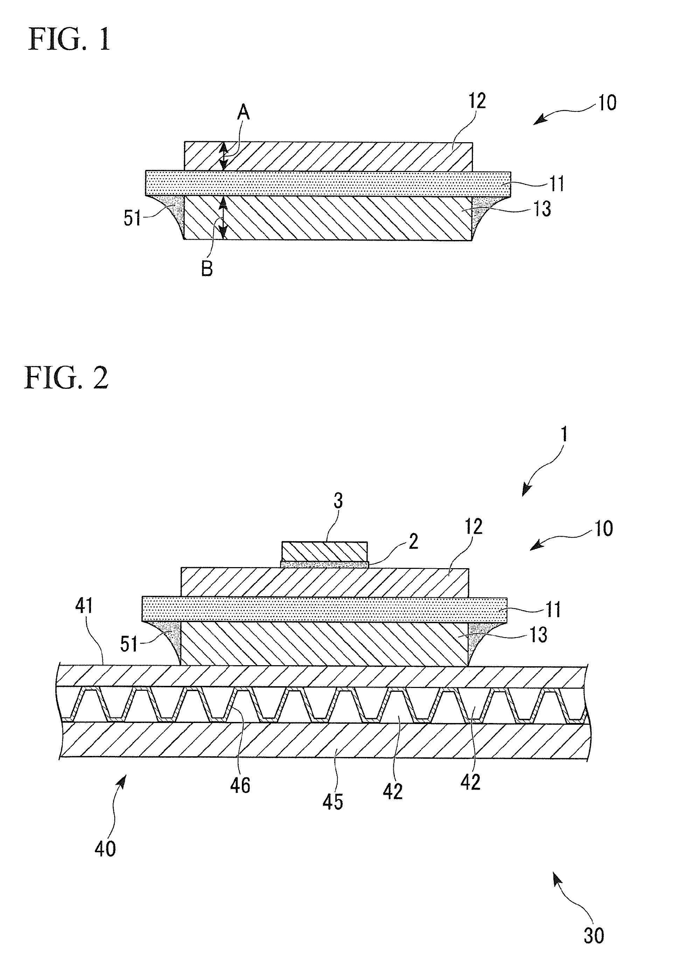

As illustrated in FIG. 1, a power module substrate 10 (bonded body) of the present embodiment includes a ceramic substrate 11 configuring an insulating layer, a circuit layer 12 provided on one surface (a top surface in FIG. 1) of the ceramic substrate 11 and a metal layer 13 provided on the other surface (a bottom surface in FIG. 1) of the ceramic substrate 11.

The ceramic substrate 11 prevents electric connection between the circuit layer 12 and the metal layer 13, and is made of, for example, highly insulating aluminum nitride (AlN). The thickness of the ceramic substrate 11 is set in a range of 0.2 mm to 1.5 mm, and is set to 0.635 mm in the embodiment.

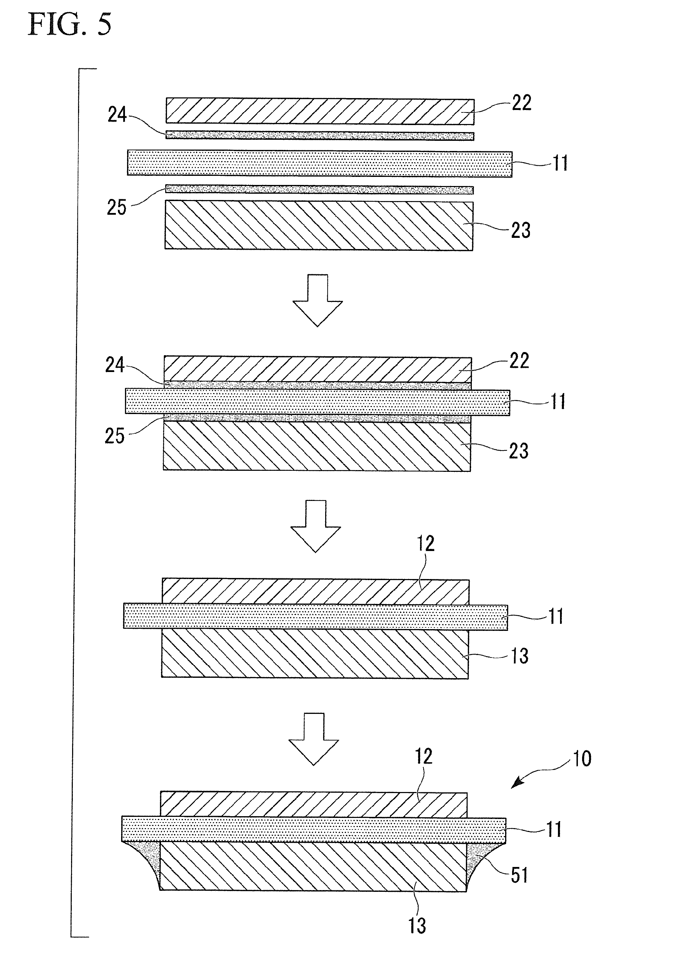

The circuit layer 12 is formed by bonding a conductive metal plate 22 to one surface (first surface) of the ceramic substrate 11 (refer to FIG. 5). In the embodiment, the circuit layer 12 is formed by bonding an aluminum plate made of a rolled plate of aluminum having a purity of 99.99% or more (so-called 4N aluminum) to the ceramic substrate 11. The thickness A of the circuit layer 12 is set in a range of 0.2 mm to 3.0 mm, and is set to 0.6 mm in the embodiment.

The metal layer 13 is formed by bonding a metal plate 23 to the other surface (second surface) of the ceramic substrate 11 (refer to FIG. 5). In the embodiment, similar to the circuit layer 12, the metal layer 13 is formed by bonding an aluminum plate made of a rolled plate of aluminum having a purity of 99.99% or more (so-called 4N aluminum) to the ceramic substrate 11. The thickness B of the metal layer 13 is set in a range of 0.2 mm to 3.0 mm, and is set to 1.6 mm in the embodiment.

In the embodiment, the ratio B/A of the thickness of the metal layer 13 to the thickness of the circuit layer 12 is set in a range of 1.0≤B/A≤20, and more preferably set in a range of 1.5≤B/A≤20. In the embodiment, B/A is set to 1.6/0.6=2.667.

In the embodiment, a flux component intrusion-preventing layer 51 is formed on a circumferential edge section of a bonding interface between the ceramic substrate 11 and the metal layer 13 in the power module substrate 10. As illustrated in FIG. 1, the flux component intrusion-preventing layer 51 forms a fillet shape. That is, the flux component intrusion-preventing layer 51 is formed on almost the entire bottom surface of the circumferential edge section excluding the bonding surface of the ceramic substrate 11 with the metal layer 13 and substantially the entire side surfaces of the metal layer 13, and the circumferential edge section of the bonding interface between the ceramic substrate 11 and the metal layer 13 is fully covered with the flux component intrusion-preventing layer 51.

The flux component intrusion-preventing layer 51 contains an oxide and a resin, and more specifically, the content of the oxide is 5% by volume to 60% by volume, and the remainder is the resin.

One or more of TiO₂, SiO₂ and Al₂O₃ are used as the oxide. The grain diameter of the oxide is preferably in a range of 0.01 µm to 20 µm, and more preferably in a range of 0.1 µm to 20 µm.

When a heat sink 40 (material to be bonded) is bonded to the other surface of the metal layer 13 in the power module substrate 10 (bonded body) through Nocolok brazing for which a flux mainly containing KAlF₄ is used as described below, TiO₂ is preferably used as an oxide decomposing KAlF₄ that is a flux component. More specifically, TiO₂ is preferably contained in a range of 5% by volume to 60% by volume.

An acrylic resin, a cellulose resin, a butyral resin and the like can be used as the resin. Among the above-described resins, the acrylic resin is preferably used.

### [Power module substrate with a heat sink]

Next, a power module substrate with a heat sink 30 and a power module 1 for which the power module substrate 10 is used will be described with reference to FIG. 2. The power module 1 includes the power module substrate with a heat sink 30 and a semiconductor chip 3 bonded to a surface of the circuit layer 12 through a solder layer 2.

The power module substrate with a heat sink 30 is obtained by bonding the heat sink 40 to the power module substrate 10. In the embodiment, the heat sink 40 and the power module substrate 10 are bonded together through Nocolok brazing for which the flux mainly containing KAlF₄ is used.

The heat sink 40 cools the power module substrate 10. The heat sink 40 of the embodiment includes a top board 41 bonded to the power module substrate 10, a bottom board 45 disposed so as to face the top board 41, and a corrugated fin 46 interposed between the top board 41 and the bottom board 45, and a flow channel 42 through which a cooling medium flows is defined by the top board 41, the bottom board 45 and the corrugated fin 46.

The resin in the flux component intrusion-preventing layer 51 in the power module substrate 10 is thermally decomposed and removed due to heat generated when the heat sink 40 is bonded. Therefore, the flux component intrusion-preventing layer 51 in the power module substrate with a heat sink 30 illustrated in FIG. 2 rarely contains a resin component, and is made of the oxide (for example, TiO₂ in the embodiment).

### [Paste for forming the flux component intrusion-preventing layer]

Next, paste for forming the flux component intrusion-preventing layer 50 used when forming the flux component intrusion-preventing layer 51 in the power module substrate 10 will be described.

The paste for forming the flux component intrusion-preventing layer 50 contains the oxide, the resin and a solvent, and more specifically, the content of the oxide is in a range of 10% by mass to 80% by mass of the mass of the paste, the content of the resin is in a range of 5% by mass to 30% by mass of the mass of the paste, and the remainder is the solvent.

When the flux mainly containing KAlF₄ is used, TiO₂ that decomposes KAlF₄ that is a flux component is preferably used as the oxide, and, in this case, TiO₂ is preferably contained in a range of 10% by mass to 80% by mass.

A non-polar solvent such as cyclohexane, methylcyclohexane, ethylcyclohexane or dibutyl ether is preferred as the solvent, and one of the above-described solvents or a mixture of two or more solvents is used. The resin is preferably dissolved in the solvent.

For the paste for forming the flux component intrusion-preventing layer 50 of the embodiment, the viscosity at a shear rate of 10s⁻¹ at a temperature of 25°C is set in a range of 10 mPa·s to 20000 mPa·s, and the viscosity at a shear rate of 100s⁻¹ at a temperature of 25°C is set in a range of 10 mPa·s to 5000 mPa·s.

More preferably, the viscosity at a shear rate of 10s⁻¹ at a temperature of 25°C is set in a range of 100 mPa·s to 10000 mPa·s, and the viscosity at a shear rate of 100s⁻¹ at a temperature of 25°C is set in a range of 50 mPa·s to 2500 mPa·s.

The viscosity at a predetermined shear rate indicates the viscosity value obtained three minutes after a predetermined shear rate is supplied to the paste for forming the flux component intrusion-preventing layer 50 by rotating a cone (4°, diameter: 40 mm) used as a measurement jig in a stress meter.

The paste for forming the flux component intrusion-preventing layer 50 may contain a dispersant as necessary. In this case, the content of the resin may be decreased by the content of the dispersant. The use of the dispersant can stabilize the dispersion of an oxide component. Examples of the dispersant include an anionic surfactant, a cationic surfactant and a nonionic surfactant. A preferred content of the dispersant is not limited, and is, for example, in a range of 0.01% by mass to 5% by mass of the total amount of the paste. When the content of the dispersant is within the above-described range, a dispersion effect is obtained, and the effect of the remaining dispersant is not easily generated.

### [Method for manufacturing the paste for forming the flux component intrusion-preventing layer]

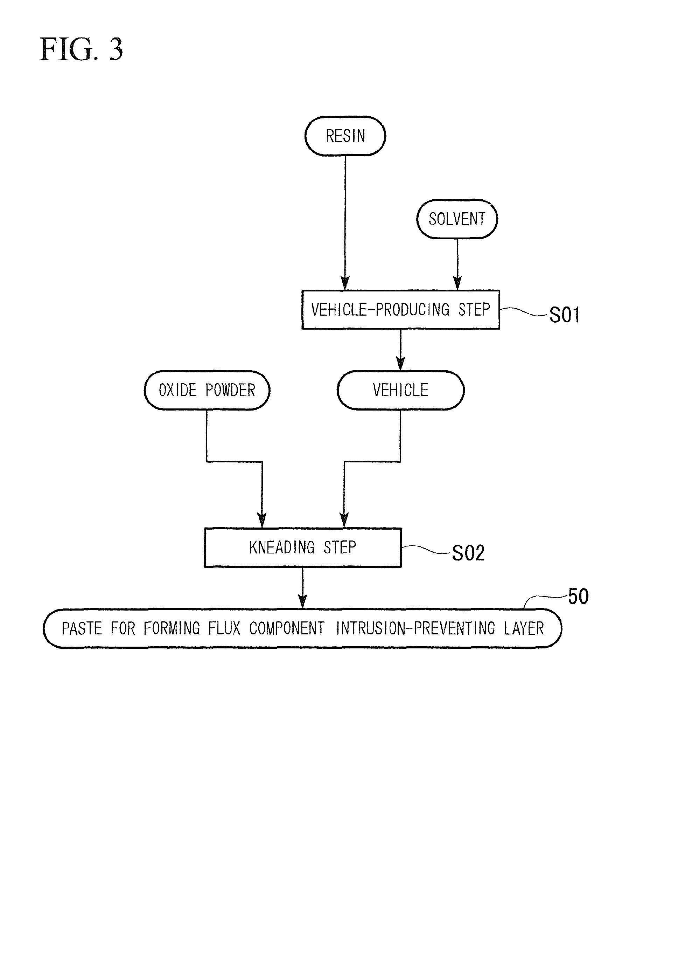

Next, a method for manufacturing the paste for forming the flux component intrusion-preventing layer 50 will be described with reference to a flowchart illustrated in FIG. 3.

First, the solvent and the resin are mixed and stirred using a stirring device such as a planetary stirring device, thereby producing a vehicle containing the resin dissolved in the solvent (vehicle-producing step S01).

Next, oxide powder (TiO₂ powder) and the vehicle are stirred using the stirring device such as the planetary stirring device (kneading step S02). The paste for forming the flux component intrusion-preventing layer 50 is manufactured in the above-described manner.

### [Method for manufacturing the power module substrate with a heat sink]

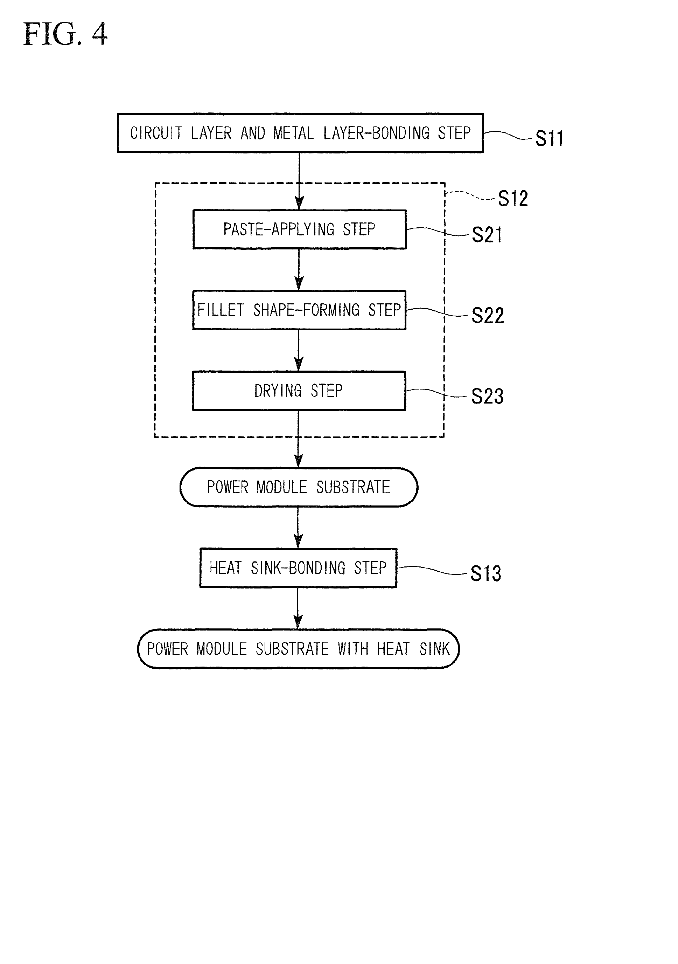

Next, a method for manufacturing the power module substrate with a heat sink will be described with reference to FIGS. 4 to 7.

### (Circuit layer and metal layer-bonding step S11)

First, as illustrated in FIG. 5, the metal plate 22 (4N aluminum rolled plate) that serves as the circuit layer 12 is laminated on one surface of the ceramic substrate 11 through a brazing filler metal foil 24 having a thickness in a range of 5 µm to 50 µm (14 µm in the embodiment). The metal plate 23 (4N aluminum rolled plate) that serves as the metal layer 13 is laminated on the other surface of the ceramic substrate 11 through a brazing filler metal foil 25 having a thickness in a range of 5 µm to 50 µm (14 µm in the embodiment). In the embodiment, for example, an Al-Si-based brazing filler metal containing Si that is a melting point-lowering element is used as the brazing filler metal foils 24 and 25.

Next, the metal plate 22, the ceramic substrate 11 and the metal plate 23 in a state of being pressurized (at a pressure in a range of 1 kgf/cm² to 5 kgf/cm²) in a lamination direction are loaded into a heating furnace, and heated. Then, the brazing filler metal foils 24 and 25 and some of the metal plates 22 and 23 are melted, and molten metal regions are formed respectively in the interfaces between the metal plates 22 and 23 and the ceramic substrate 11. The heating temperature is set, for example, in a range of 550°C to 650°C, and the heating time is set in a range of 30 minutes to 180 minutes.

Next, the molten metal regions formed respectively in the interfaces between the metal plates 22 and 23 and the ceramic substrate 11 are solidified, thereby bonding the ceramic substrate 11 and the metal plate 22 and the metal plate 23.

### (Flux component intrusion-preventing layer-forming step S12)

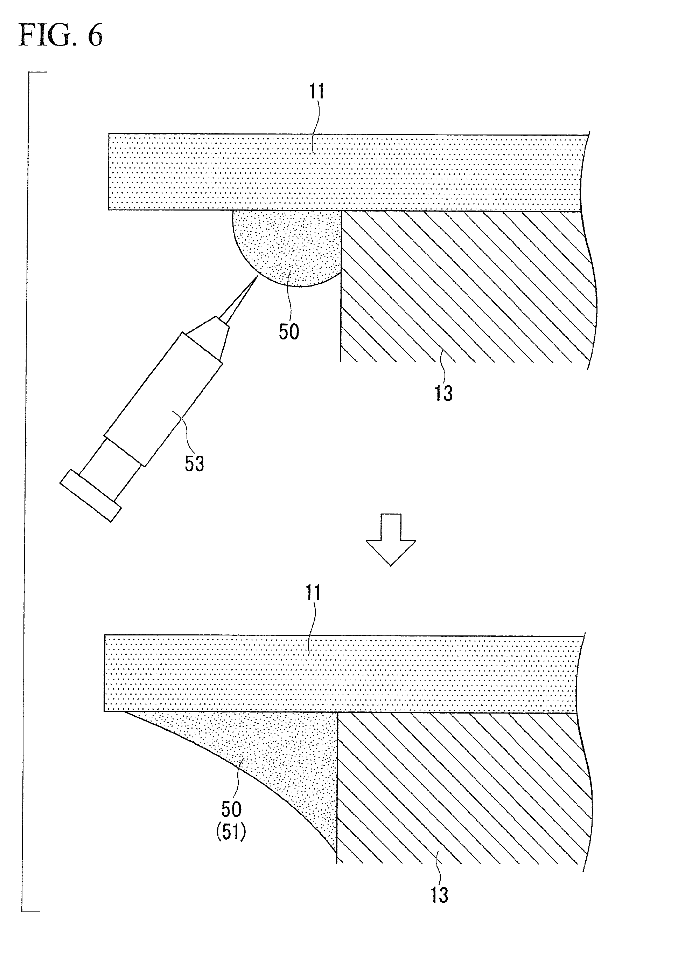

Next, the flux component intrusion-preventing layer 51 is formed at the circumferential edge of the bonding interface between the ceramic substrate 11 and the metal layer 13 (metal plate 23). A method for forming the flux component intrusion-preventing layer 51 will be described using FIG. 6.

First, the paste for forming the flux component intrusion-preventing layer 50 is applied to the circumferential edge of the bonding interface between the ceramic substrate 11 and the metal layer 13 (metal plate 23) using a dispenser 53 (paste-applying step S21).

The applied paste for forming the flux component intrusion-preventing layer 50 is left to stand. Then, the paste for forming the flux component intrusion-preventing layer 50 automatically sags to the appropriate extent so as to form a fillet shape as illustrated in FIG. 6 (fillet shape-forming step S22).

Next, the paste is dried under conditions of 50°C to 150°C and 3 minutes to 30 minutes (drying step S23). At this time, the solvent in the paste for forming the flux component intrusion-preventing layer 50 is removed, and the flux component intrusion-preventing layer 51 including the oxide (for example, TiO₂ in the embodiment) and the resin (for example, the acrylic resin in the embodiment) is formed.

### (Heat sink-bonding step S13)

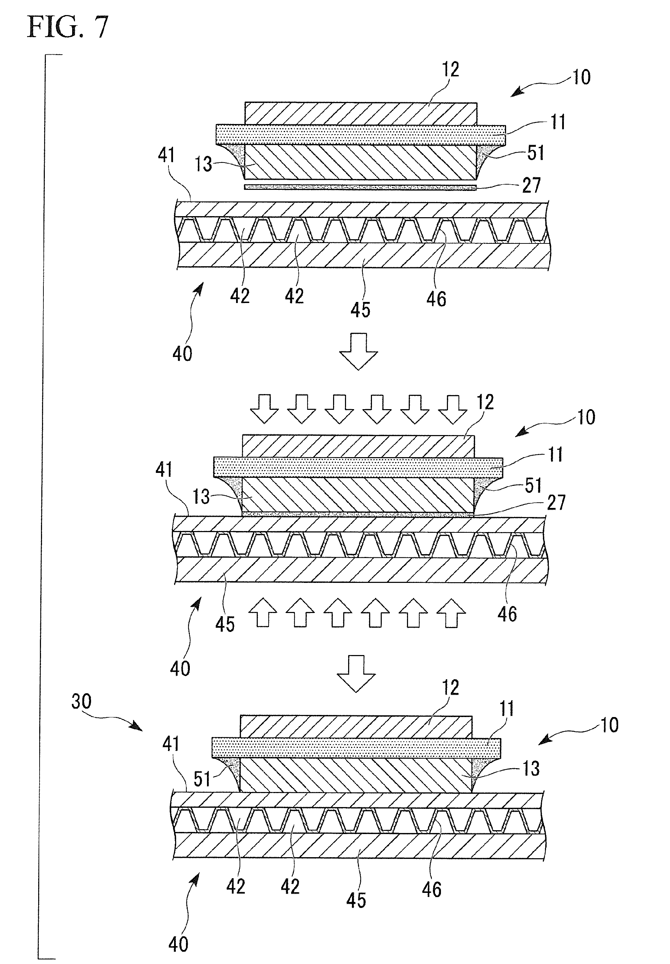

Next, the heat sink 40 is bonded to the other surface of the metal layer 13 in the power module substrate 10 as illustrated in FIG. 7. First, an Al-Si-based brazing filler metal foil 27 and the flux mainly containing KAlF₄ (not illustrated) are interposed between the metal layer 13 in the power module substrate 10 and the top board 41 of the heat sink 40.

Next, the laminated power module substrate 10 and heat sink 40 in a state of being pressurized (at a pressure in a range of 0 kgf/cm² to 10 kgf/cm²) in a lamination direction are loaded into a atmosphere heating furnace, and heated, thereby forming molten metal regions between the metal layer 13 and the top board 41 of the heat sink 40. For example, an inert gas atmosphere such as nitrogen gas is set in the atmosphere heating furnace, and the heating temperature is set in a range of 550°C to 630°C.

After the heating, the above-described molten metal regions are solidified, thereby bonding the metal layer 13 in the power module substrate 10 and the top board 41 of the heat sink 40. At this time, an oxide coating is formed on the surfaces of the metal layer 13 and the top board 41, but the oxide coatings are removed by the above-described flux. In addition, a flux component is liquefied and gasified so as to move toward the ceramic substrate 11. In the above-described manner, the power module substrate with a heat sink 30 having the heat sink 40 and the power module substrate 10 bonded together is manufactured.

According to the power module substrate 10 configured as described above, since the flux component intrusion-preventing layer 51 containing the oxide and the resin is formed at the circumferential edge section of the bonding interface between the ceramic substrate 11 and the metal layer 13, even when KAlF₄ that is the flux component moves toward the ceramic substrate 11 when bonding the heat sink 40 to the other surface of the metal layer 13 using the flux, the KAlF₄ comes into contact with the oxide in the flux component intrusion-preventing layer 51 and is decomposed, it is possible to suppress the entering of the KAlF₄ that is the flux component into the bonding interface between the ceramic substrate 11 and the metal layer 13.

Since the composition of the flux component intrusion-preventing layer 51 contains the oxide in a range of 5% by volume to 60% by volume and the remainder of the resin, it is possible to reliably decompose the flux component, and to reliably suppress the entering of the flux component into the bonding interface between the ceramic substrate 11 and the metal layer 13. Since the content of the oxide is set to 60% by volume or less, the content of the resin in the flux component intrusion-preventing layer 51 is ensured, and it is possible to prevent the detachment of the flux component intrusion-preventing layer 51 from the power module substrate 10 until the heat sink-bonding step S13 of bonding the heat sink 40 using the adhesive force of the resin component.

In the embodiment, since the flux component intrusion-preventing layer 51 forms a fillet shape, the flux component intrusion-preventing layer 51 is formed so as to extend up to the other surface of the ceramic substrate 11 and the side surfaces of the metal layer 13 respectively, and it is possible to reliably suppress the entering of the flux component into the bonding interface between the ceramic substrate 11 and the metal layer 13.

Furthermore, since the oxide in the flux component intrusion-preventing layer 51 is supposed to be one or more of TiO₂, SiO₂ and Al₂O₃, and TiO₂ is contained in the embodiment, it becomes possible to reliably decompose the flux mainly containing KAlF₄ used for the Nocolok brazing.

An acrylic resin is used as the resin contained in the flux component intrusion-preventing layer 51. The acrylic resin is depolymerized during heating, has a favorable thermal decomposition characteristic in an inert gas atmosphere, and is capable of suppressing the remaining of the resin in the flux component intrusion-preventing layer 51 after firing.

Furthermore, according to the power module substrate with a heat sink 30, since the flux component intrusion-preventing layer 51 is formed at the circumferential edge of the bonding interface between the ceramic substrate 11 and the metal layer 13, when bonding the heat sink 40, the intrusion of KAlF₄ that is the flux component into the bonding interface between the ceramic substrate 11 and the metal layer 13 is prevented. Therefore, it becomes possible to provide the power module substrate with a heat sink 30 having excellent bonding reliability between the ceramic substrate 11 and the metal layer 13.

According to the paste for forming the flux component intrusion-preventing layer 50, since the oxide decomposing the flux component is contained, when KAlF₄ comes into contact with the flux component intrusion-preventing layer 51, the KAlF₄ is decomposed, and it is possible to suppress the entering of the flux component KAlF₄ into the bonding interface between the ceramic substrate 11 and the metal layer 13. Particularly, when TiO₂ that is a preferred oxide decomposing the flux mainly containing KAlF₄ is contained, it is possible to efficiently decompose the KAlF₄ when the KAlF₄ comes into contact with the flux component intrusion-preventing layer 51.

Since the applied paste for forming the flux component intrusion-preventing layer 50 has a viscosity at a shear rate of 10s⁻¹ at a temperature of 25°C set in a range of 10 mPa·s to 20000 mPa·s and a viscosity at a shear rate of 100s⁻¹ at a temperature of 25°C set in a range of 10 mPa·s to 5000 mPa·s, it is possible to favorably apply the paste for forming the flux component intrusion-preventing layer 50 to the periphery of the bonding interface between the ceramic substrate 11 and the metal layer 13. The applied paste for forming the flux component intrusion-preventing layer 50 is made to sag to an appropriate extent so as to form a favorable fillet shape as illustrated in FIGS. 1 and 2, and it is possible to reliably form the flux component intrusion-preventing layer 51. Particularly, when the viscosity at a shear rate of 10s⁻¹ at a temperature of 25°C is set in a range of 10 mPa·s to 10000 mPa·s, and the viscosity at a shear rate of 100s⁻¹ at a temperature of 25°C is set in a range of 50 mPa·s to 2500 mPa·s, it is possible to more favorably apply the paste for forming the flux component intrusion-preventing layer 50 to the periphery of the bonding interface between the ceramic substrate 11 and the metal layer 13, and a more favorable fillet shape is formed.

Particularly, when an acrylic resin is contained as the resin, the resin is depolymerized due to heating during bonding, and is favorably thermally decomposed even in an inert gas atmosphere, whereby it is possible to suppress the remaining of the resin in the flux component intrusion-preventing layer 51 after firing.

Furthermore, in the embodiment, since a non-polar solvent such as cyclohexane, methylcyclohexane, ethylcyclohexane or dibutyl ether is used as the solvent, it becomes possible to accelerate the adsorption of the oxide powder (TiO₂ powder) to the resin, and it becomes possible to stably disperse the oxide powder (TiO₂ powder).

In the paste for forming the flux component intrusion-preventing layer 50 of the embodiment, since the content of the oxide (TiO₂) is set in a range of 10% by mass to 80% by mass, the content of the resin is set in a range of 5% by mass to 30% by mass, and the remainder is the solvent, it is possible to reliably decompose and detoxify the flux component, to hold the applied and formed fillet shape, and to reliably form the flux component intrusion-preventing layer 51.

Furthermore, according to the method for bonding the bonded body of the embodiment, it is possible to suppress the intrusion of KAlF₄ that is the flux component into the bonding interface between the ceramic substrate 11 and the metal layer 13 in the power module substrate 10, and it becomes possible to favorably bond the power module substrate 10 and the heat sink 40 without decreasing the bonding reliability at the bonding interface.

Thus far, the embodiment of the invention has been described, but the invention is not limited thereto, and can be modified as appropriate within the scope of the technical concept of the invention.

For example, while an aluminum plate is used as the circuit layer in the description, the circuit layer is not limited thereto, and the circuit layer may be made of an aluminum alloy plate, a copper plate or a copper alloy plate.

A ceramic substrate made of AlN is used in the description, the ceramic substrate is not limited thereto, and the ceramic substrate may be a ceramic substrate made of Al₂O₃, Si₃N₄ or the like, and may be an insulating material.

Furthermore, a method for bonding the ceramic substrate, the circuit layer and the metal layer is not limited to the embodiment, and the ceramic substrate, the circuit layer and the metal layer may be bonded together using other methods.

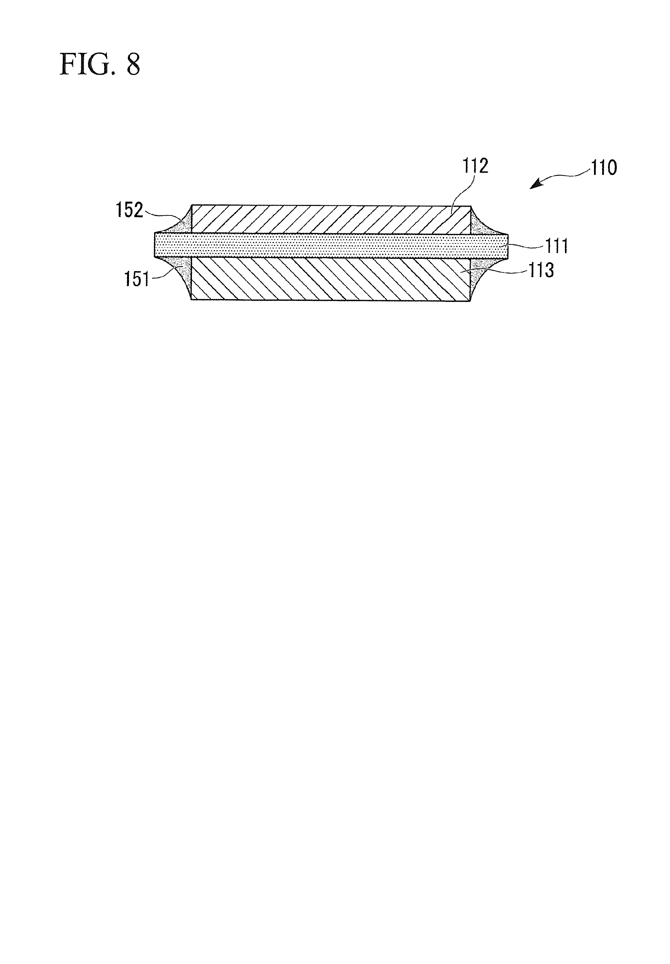

In addition, as in a power module substrate 110 illustrated in FIG. 8, it is possible to form a flux component intrusion-preventing layer 151 at the circumferential edge of the bonding interface between a ceramic substrate 111 and a metal layer 113 and form a flux component intrusion-preventing layer 152 at the circumferential edge of the bonding interface between a circuit layer 112 and the ceramic substrate 111. Particularly, when the flux component gasifies, since there is a concern that the flux component may pass through the ceramic substrate 111 and intrude the bonding interface between the circuit layer 112 and the ceramic substrate 111, it is preferable to form the flux component intrusion-preventing layer 152 at the circumferential edge of the bonding interface between the circuit layer 112 and the ceramic substrate 111.

For example, the raw material and blending amount of the paste for forming the flux component intrusion-preventing layer are not limited to the raw material and the blending amount described in the embodiment, and other oxides, other resins and other solvents may be used.

The oxide decomposing the flux is not limited to TiO₂, and a mixture of one or more of TiO₂, SiO₂ and Al₂O₃ may be used, or other oxides may be used. The kind of the oxide is preferably selected depending on the flux to be used for bonding.

An acrylic resin is used as the resin in the description, but the resin is not limited thereto, and other resins may be used.

Furthermore, a non-polar solvent such as cyclohexane, methylcyclohexane, ethylcyclohexane or dibutyl ether is used as the solvent in the description, the solvent is not limited thereto, and other solvents may be used.

Furthermore, in the embodiment, the bonding of the power module substrate (bonded body) obtained by bonding the ceramic substrate and the metal plate and the heat sink (material to be bonded) using the flux mainly containing KAlF₄ is described, but the bonding method is not limited thereto, and it is possible to apply bonding of a bonded body having a first member and a second member bonded through a bonding interface and a material to be bonded using a flux.

### [Examples]

Hereinafter, the results of tests carried out to confirm the effects of the invention will be described.

Paste for a flux component intrusion-preventing layer having a composition illustrated in Table 1 was manufactured in the order descried in the flowchart of FIG. 3. In Comparative Example A2, the paste for a flux component intrusion-preventing layer was not used.

In an organic substance-mixing step S1, stirring was carried out for 30 minutes using a planetary stirring device (manufactured by Thinky, "AR-250" (trade name)), thereby dissolving a resin. In a kneading step S2, stirring was carried out for 30 minutes using the planetary stirring device (manufactured by Thinky, "AR-250" (trade name)).

A flux component intrusion-preventing layer was formed on a power module substrate disclosed in the above-described embodiment using the obtained paste for the flux component intrusion-preventing layer. In Comparative Example A2, the flux component intrusion-preventing layer was not formed. In individual examples and individual comparative examples, a ceramic substrate had dimensions of 30 mmx20 mm×0.635 mm, a circuit layer had dimensions of 13 mm×10 mm×0.6 mm, and a metal layer had dimensions of 13 mm×10 mm×1.6 mm. A top board of a heat sink was provided with dimensions of 50 mmx50 mmx7 mm.

A needle having an inner diameter of 0.26 mm was attached to a dispenser (manufactured by Musashi Engineering Co., Ltd., "Super∑ X-V2" (trade name)), and the paste for the flux component intrusion-preventing layer was applied at an application pressure of 0.20 kPa to the circumferential edge of a bonding interface between the ceramic substrate and the metal layer in the power module substrate. After the application, a drying treatment was carried out for five minutes at 80°C on a hot plate.

First, a detachment test of a flux component entrance-preventing layer was carried out.

The power module substrate on which the flux component intrusion-preventing layer was formed was placed on a plastic tray, and shaken for three hours at 300 rpm in a shaker, thereby observing the occurrence of the detachment of the flux component intrusion-preventing layer. A substrate in which the detachment of the flux component intrusion-preventing layer was not admitted was evaluated to be A, a substrate in which the slight detachment of a 0.5 mm or smaller piece was admitted was evaluated to be B, and a substrate in which the detachment of a 0.5 mm or larger piece was admitted was evaluated to be C. The slight detachment of a 0.5 mm or smaller piece does not cause a practical problem.

Next, only the top board of the heat sink was bonded to the power module substrate through Nocolok brazing, thereby producing a power module substrate with a heat sink.

First, the bonding interface between the ceramic substrate and the metal layer in the obtained power module substrate with a heat sink was observed using an ultrasonic test device (manufactured by Hitachi Engineering And Services Co., Ltd. "Fine SAT FS-200" (trade name)), and the initial bonding reliability was evaluated based on the occurrence of the detachment.

Next, 1000 cycles of thermal cycling were carried out in a range of -40°C to 125°C on the power module substrate with a heat sink. The bonding interface between the ceramic substrate and the metal layer in the obtained power module substrate with a heat sink was observed using an ultrasonic test device (manufactured by Hitachi Engineering And Services Co., Ltd. "Fine SAT FS-200" (trade name)), and the bonding reliability after the thermal cycling was evaluated based on the occurrence of the detachment.

Since the metal layer begins to peel from an outer circumferential section during the Nocolok bonding, and a peeled part appears as a white part in the bonding interface in an ultrasonic test image, the length of the white part along the outer circumferential section of the metal layer was measured as the peeling length. A case in which the metal layer was not peeled was evaluated to be S, a case in which the fraction (peeling length ratio) of the peeling length in the length of a side of the bonding interface was 30% or less was evaluated to be A, and a case in which the peeling length ratio exceeded 30% was evaluated to be C. When the peeling length ratio was 30% or less, the bonding reliability was evaluated to cause no actual problem. The evaluation results and the peeling lengths are described in Table 2.

**[Table 1]**

| (mass%) | | | | | | | | | |
|---|---|---|---|---|---|---|---|---|---|
| | Example A1 | Example A2 | Example A3 | Example A4 | Example A5 | Example A6 | Example A7 | Comparative Example A1 | Comparative Example A2 |
| TiO₂ | 30 | 50 | 8 | - | - | 50 | - | - | - |
| SiO₂ | - | - | - | 40 | - | - | 3 | - | - |
| Al₂O₃ | - | - | - | - | 20 | - | - | - | - |
| Si₃N₄ | - | - | - | - | - | - | - | 40 | - |
| Resin | 15 | 10 | 26 | 15 | 20 | 5 | 29 | 10 | - |
| Solvent | 55 | 40 | 66 | 45 | 60 | 45 | 68 | 50 | - |
| Amount of dried oxide vol% | 31.9 | 53.9 | 6.7 | 54.7 | 20.1 | 70.1 | 4.5 | 53.8 | - |

| | | | | | | | | | |
|---|---|---|---|---|---|---|---|---|---|
| TiO₂ grain diameter of 2.0 µm SiO₂ grain diameter of 20 µm Al₂O₃ grain diameter of 1.0 µm Si₃N₄ grain diameter of 2.0 µm Resin acrylic resin, molecular weight of 150000, T_{g} 60°C Solvent ethylcyclohexane | | | | | | | | | |

**[Table 2]**

| | | Example A1 | Example A2 | Example A3 | Example A4 | Example A5 | Example A6 | Example A7 | Comparative Example A1 | Comparative Example A2 |
|---|---|---|---|---|---|---|---|---|---|---|
| Detachment test | | A | A | A | A | A | B | A | A | - |
| Bonding reliability (initial) | Evaluation | S | S | S | S | S | S | A | C | C |
| | Peeling length ratio | 0% | 0% | 0% | 0% | 0% | 0% | 10% | 35% | 40% |
| Bonding reliability (after 1000 cycles) | Evaluation | S | S | S | S | S | S | A | C | C |
| | Peeling length ratio | 0% | 0% | 0% | 0% | 0% | 0% | 15% | 40% | 50% |

In Comparative Example A1 in which the flux component intrusion-preventing layer containing no oxide was formed, it was confirmed that the evaluation of the detachment test was favorable, but the bonding reliability was poor. It is assumed that, since the flux component intrusion-preventing layer contained no oxide, it was not possible to decompose the flux component, the flux component intruded into the bonding interface between the ceramic substrate and the metal layer, and the bonding reliability degraded.

In Comparative Example A2 in which paste for forming the flux component intrusion-preventing layer was not formed, it was confirmed that the bonding reliability was poor. This is assumed that the flux component intruded into the bonding interface between the ceramic substrate and the metal layer, and the bonding reliability degraded.

On the contrary, in Examples A1 to A7 in which the flux component intrusion-preventing layer containing the oxide was formed, it was confirmed that the bonding reliability was favorable. It is assumed that, since KAlF₄ that was the flux component was decomposed when coming into contact with the flux component-intrusion preventing layer, the intrusion of the flux component into the bonding interface between the ceramic substrate and the metal layer was prevented, and the bonding reliability became favorable.

Furthermore, in Example A6 in which the content (the amount of the oxide after drying) of the oxide in the flux component intrusion-preventing layer was set to 70.1 %, since the content of the resin was small, detachment was admitted in some of the flux component intrusion-preventing layer in the detachment test.

In Example A7 in which the content (the amount of the oxide after drying) of the oxide in the flux component intrusion-preventing layer was set to 4.5%, since the content of the oxide was small, compared with Examples A1 to A6, the slight degradation of the bonding reliability was admitted.

As a result of the above-described confirmation tests, it was confirmed that, according to the invention, it was possible to prevent the degradation of the bonding reliability between the ceramic substrate and the metal layer when bonding the heat sink.

Furthermore, it was confirmed that, when the content of the oxide in the flux component intrusion-preventing layer was desirably set in a range of 5% by volume to 60% by volume, it was possible to prevent the detachment of the flux component intrusion-preventing layer and to more reliably prevent the degradation of the bonding reliability.

Hereinafter, the results of tests carried out to confirm the effects of the paste will be described.

The paste for the flux component intrusion-preventing layer having a composition illustrated in Table 3 was manufactured in the order descried in the flowchart of FIG. 3. In an organic substance-mixing step S01, stirring was carried out for 30 minutes using a planetary stirring device (manufactured by Thinky, "AR-250" (trade name)), thereby dissolving a resin in a solvent.

In a kneading step S02, stirring was carried out for five minutes using the planetary stirring device (manufactured by Thinky, "AR-250" (trade name)).

For the obtained paste for the flux component intrusion-preventing layer, the viscosity at a shear rate of 10s⁻¹ at a temperature of 25°C and the viscosity at a shear rate of 100s⁻¹ at a temperature of 25°C were measured.

In a stress rheometer (manufactured by TA Instruments Japan Inc., "AR-1000" (trade name)), a cone (4°, diameter: 40 mm) was used as a measurement jig, and was rotated so as to supply a predetermined shear rate to the paste for the flux component intrusion-preventing layer, and the viscosity was measured after three minutes. The measurement results are described in Table 4.

A flux component intrusion-preventing layer of the power module substrate disclosed in the above-described embodiment was formed using the paste for the flux component intrusion-preventing layer. A ceramic substrate had dimensions of 30 mmx20 mm×0.635 mm, a circuit layer had dimensions of 13 mm×10 mm×0.6 mm, a metal layer had dimensions of 13 mm×10 mm×1.6 mm, and a top board of a heat sink was provided with dimensions of 50 mmx50 mmx7 mm.

A needle having an inner diameter of 0.26 mm was attached to the dispenser (manufactured by Musashi Engineering Co., Ltd., "Super∑ X-V2" (trade name)), and the paste for the flux component intrusion-preventing layer was applied at an application pressure of 0.20 kPa to the circumferential edge of a bonding interface between the ceramic substrate and the metal layer in the power module substrate. After the application, a drying treatment was carried out for five minutes at 80°C on the hot plate.

First, the fillet shape was evaluated.

The flux component intrusion-preventing layer was observed using an optical microscope, and the presence of the vacancy or void of the paste for the flux component intrusion-preventing layer was checked. A flux component intrusion-preventing layer in which neither vacancy nor void was observed was evaluated to be A, a flux component intrusion-preventing layer in which only one 3 mm or smaller vacancy or void was observed was evaluated to be B, and a flux component intrusion-preventing layer in which a vacancy or void having a length of over 3 mm was observed or two or more 3 mm or smaller vacancies or voids were observed was evaluated to be C. A flux component intrusion-preventing layer including one vacancy or void having a length of 3 mm or less does not cause a practical problem.

Next, only the top board of the heat sink was bonded to the power module substrate through Nocolok brazing, thereby producing a power module substrate with a heat sink.

First, the bonding interface between the ceramic substrate and the metal layer in the obtained power module substrate with a heat sink was observed using an ultrasonic test device (manufactured by Hitachi Engineering And Services Co., Ltd. "Fine SAT FS-200" (trade name)), and the initial bonding reliability was evaluated based on the occurrence of the detachment.

Next, 1000 cycles of thermal cycling was carried out in a range of -40°C to 125°C on the power module substrate with a heat sink. The bonding interface between the ceramic substrate and the metal layer in the obtained power module substrate with a heat sink was observed using an ultrasonic test device (manufactured by Hitachi Engineering And Services Co., Ltd. "Fine SAT FS-200" (trade name)), and the bonding reliability after the thermal cycling was evaluated based on the occurrence of the detachment.

Since the metal layer begins to peel from an outer circumferential section during the Nocolok bonding, and a peeled part appears as a white part in the bonding interface in an ultrasonic test image, the length of the white part along the outer circumferential section of the metal layer was measured as the peeling length. A case in which the metal layer was not peeled was evaluated to be A, a case in which the fraction (peeling length ratio) of the peeling length in the length of a side of the bonding interface was 30% or less was evaluated to be B, and a case in which the peeling length ratio exceeded 30% was evaluated to be C. The evaluation results and the peeling lengths are described in Table 4.

**[Table 3]**

| | Oxide | | | Resin | | | | Solvent | |
|---|---|---|---|---|---|---|---|---|---|
| | Kind | Grain diameter | % by mass | Kind | Molecular weight | T_{g} (°C) | % by mass | Kind | % by mass |
| Example B1 | TiO₂ | 2.0 µm | 50 | Acrylic resin | 150000 | 60 | 10 | Ethylcyclohexane | 40 |
| Example B2 | TiO₂ | 0.2 µm | 40 | Acrylic resin | 150000 | 60 | 10 | Dibutyl ether | 50 |
| Example B3 | TiO₂ | 2.0 µm | 35 | Acrylic resin | 50000 | 55 | 15 | Ethylcyclohexane | 50 |
| Example B4 | SiO₂ | 20 µm | 40 | Acrylic resin | 50000 | 55 | 15 | Ethylcyclohexane | 45 |
| Example B5 | Al₂O₃ | 1.0 µm | 40 | Acrylic resin | 150000 | 60 | 10 | Hexyloxyethanol | 50 |
| Example B6 | SiO₂ | 20 µm | 20 | Acrylic resin | 150000 | 60 | 24 | Ethylcyclohexane | 56 |
| Example B7 | TiO₂ | 2.0 µm | 70 | Acrylic resin | 150000 | 60 | 10 | Ethylcyclohexane | 20 |
| Comparative Example B1 | Si₃N₄ | 2.0 µm | 40 | Acrylic resin | 150000 | 60 | 10 | Dibutyl ether | 50 |
| Comparative Example B2 | TiO₂ | 2.0 µm | 50 | Acrylic resin | 150000 | 60 | 10 | Ethylene glycol monobutyl ether | 40 |
| Comparative Example B3 | TiO₂ | 0.2 µm | 50 | Acrylic resin | 50000 | 55 | 10 | Ethylcyclohexane | 40 |

**[Table 4]**

| | 10s⁻¹ viscosity (mPa·s) | 100s⁻¹ viscosity (mPa·s) | Fillet shape | Bonding reliability (initial) | | Bonding reliability (after 1000 cycles) | |
|---|---|---|---|---|---|---|---|
| | | | | Evaluation | Peeling length ratio | Evaluation | Peeling length ratio |
| Example B1 | 3300 | 900 | A | A | 0% | A | 0% |
| Example B2 | 7200 | 1800 | A | A | 0% | A | 0% |
| Example B3 | 900 | 200 | A | A | 0% | A | 0% |
| Example B4 | 4200 | 2000 | A | A | 0% | A | 0% |
| Example B5 | 10000 | 3800 | B | A | 0% | A | 0% |
| Example B6 | 50 | 50 | B | A | 0% | A | 0% |
| Example B7 | 18000 | 4500 | B | A | 0% | A | 0% |
| Comparative Example B1 | 4000 | 1000 | A | C | 35% | C | 40% |
| Comparative Example B2 | 28000 | 2000 | C | B | 15% | C | 30% |
| Comparative Example B3 | 30000 | 8000 | C | B | 20% | C | 40% |

In Examples B1 to B7 in which the viscosity at a shear rate of 10s⁻¹ at a temperature of 25°C was set in a range of 10 mPa·s to 20000 mPa·s, and the viscosity at a shear rate of 100s⁻¹ at a temperature of 25°C was set in a range of 10 mPa·s to 5000 mPa·s, it was confirmed that the initial bonding reliability and the bonding reliability after the thermal cycling were favorable. This is assumed to be because the flux component did not intrude into the bonding interface between the ceramic substrate and the metal layer.

Furthermore, in Examples B 1 to B4 in which the viscosity at a shear rate of 10s⁻¹ at a temperature of 25°C was set in a range of 100 mPa·s to 10000 mPa·s, and the viscosity at a shear rate of 100s⁻¹ at a temperature of 25°C was set in a range of 50 mPa·s to 2500 mPa·s, it was confirmed that the fillet shape after the application was favorable.

On the contrary, in Comparative Examples B 1 to B3, it was confirmed that the bonding reliability was poor.

In Comparative Example B1 containing no oxide decomposing the flux component, since the viscosity at a shear rate of 10s⁻¹ at a temperature of 25°C was set in a range of 10 mPa·s to 10000 mPa·s, and the viscosity at a shear rate of 100s⁻¹ at a temperature of 25°C was set in a range of 50 mPa·s to 2500 mPa·s, it was confirmed that the application shape is favorable. However, it is assumed that, since the oxide decomposing the flux component was not contained, it was not possible to decompose the flux component, the flux component intruded into the bonding interface between the ceramic substrate and the metal layer, and the bonding reliability degraded.

In Comparative Example B2 in which the viscosity at a shear rate of 10s⁻¹ at a temperature of 25°C was set to 28000 mPa·s, since the paste did not sag after being applied, the application shape became poor. Therefore, it is assumed that the flux component intruded into the bonding interface between the ceramic substrate and the metal layer, and the bonding reliability degraded.

In Comparative Example B3 in which the viscosity at a shear rate of 100s⁻¹ at a temperature of 25°C was set to 8000 mPa·s, it was not possible to favorably coat the paste, and the fillet shape became poor. Therefore, it is assumed that the flux component intruded into the bonding interface between the ceramic substrate and the metal layer, and the bonding reliability degraded.

As a result of the above-described confirmation tests, it was confirmed that, according to the invention, it was possible to provide paste for forming the flux component intrusion-preventing layer capable of favorably forming the flux component intrusion-preventing layer.

### Industrial Applicability

According to the invention, even when a material to be bonded is bonded using a flux, it is possible to reliably attach the flux intrusion-preventing layer and to suppress the degradation of the bonding reliability between an insulating layer and a metal plate, and therefore the invention is industrially applicable.

### Explanation of Reference

- 10: POWER MODULE SUBSTRATE
- 11: CERAMIC SUBSTRATE (INSULATING LAYER)
- 13: METAL LAYER
- 40: HEAT SINK
- 51: FLUX COMPONENT INTRUSION-PREVENTING LAYER

## Claims

1. A power module substrate comprising an insulating layer, a circuit layer formed on a first surface of the insulating layer, and a metal layer formed on a second surface of the insulating layer,
wherein the metal layer has an another surface on which a body to be bonded can be bonded, and a flux component intrusion-preventing layer containing an oxide and a resin is formed at a circumferential edge section of a bonding interface between the insulating layer and the metal layer.

2. The power module substrate according to Claim 1, wherein the flux component intrusion-preventing layer contains the oxide in a range of 5% by volume to 60% by volume, and a remainder is the resin.

3. The power module substrate according to Claim 1, wherein the oxide is one or more of TiO₂, SiO₂ and Al₂O₃.

4. A power module substrate with a heat sink comprising:
the power module substrate according to Claim 1; and
a heat sink bonded to the metal layer in the power module substrate using a flux.

5. A power module comprising:
the power module substrate according to Claim 1; and
an electronic component provided on the circuit layer.

6. Paste for forming a flux component intrusion-preventing layer for forming a flux component intrusion-preventing layer, comprising:
an oxide which decomposes a flux component;
a resin; and
a solvent,
wherein a viscosity at a shear rate of 10s⁻¹ at a temperature of 25°C is set in a range of 10 mPa·s to 20000 mPa·s, and
a viscosity at a shear rate of 100s⁻¹ at a temperature of 25°C is set in a range of 10 mPa·s to 5000 mPa·s.

7. The paste for forming a flux component intrusion-preventing layer according to Claim 6, wherein the oxide is one or more of TiO₂, SiO₂ and Al₂O₃.

8. The paste for forming a flux component intrusion-preventing layer according to Claim 6, wherein a content of the oxide is set in a range of 10% by mass to 80% by mass, a content of the resin is set in a range of 5% by mass to 30% by mass, and a remainder is the solvent.

9. A method for manufacturing a power module substrate,
the power module substrate comprising an insulating layer, a circuit layer formed on a first surface of the insulating layer, and a metal layer formed on a second surface of the insulating layer, and the metal layer having another surface on which a body to be bonded can be bonded using a flux,
the method comprising a step of forming a flux component intrusion-preventing layer which suppresses intrusion of a flux component into the bonding interface between the insulating layer and the metal layer using the paste for forming a flux component intrusion-preventing layer according to any one of Claims 6 to 8.

10. A method for manufacturing a power module substrate with a heat sink, comprising a step of bonding a heat sink to the metal layer through brazing for which a flux is used in the method for manufacturing a power module substrate according to Claim 9.

11. A method for manufacturing a power module with a heat sink, comprising a step of providing an electronic component to the circuit layer in the method for manufacturing a power module substrate with a heat sink according to Claim 10.
